# EUROPEAN PATENT SPECIFICATION

(11) **EP 4 653 939 B1**
(45) Date of publication and mention of the grant of the patent: **02.12.2026**
(21) Application number: 24218132.9
(22) Date of filing: 06.12.2024
(51) Int. Cl.: G02F 1/1333, B32B 38/18, G02F 1/13, G02F 1/1347

(54) **METHOD OF ALIGNING AND LAMINATING FOR PANELS**
VERFAHREN ZUM AUSRICHTEN UND LAMINIEREN VON PLATTEN
PROCÉDÉ D'ALIGNEMENT ET DE STRATIFICATION POUR PANNEAUX

(30) Priority: 19.05.2024 US 202463649439 P; 31.07.2024 TW 113128422
(43) Date of publication of application: 26.11.2025
(60) Divisional application: 26163348.1 / 4 733 068
(73) Proprietor: Iris Optronics Co., Ltd., Tainan City 711010 (TW)
(72) Inventor: LIAO, Chi Chang, 700022 Tainan City (TW); LIN, Hou Heng, 710008 Tainan City (TW); CHEN, Hung Tien, 709030 Tainan City (TW); HUNG, Wen Fa, 711010 Tainan City (TW)
(74) Representative: Studio Torta S.p.A.

(56) References cited:
- US-A1- 2010 002 183
- US-A1- 2011 001 974
- US-A1- 2018 267 352
- KHAN YOUSUF ET AL: "Mathematical Modeling of Photonic Crystal based Optical Filters using Machine Learning", 2018 INTERNATIONAL CONFERENCE ON COMPUTING, ELECTRONIC AND ELECTRICAL ENGINEERING (ICE CUBE), IEEE, 12 November 2018 (2018-11-12), pages 1 - 5, XP033498508, [retrieved on 20190111], DOI: 10.1109/ICECUBE.2018.8610986

## Description

### BACKGROUND

### Technical Field

The present invention relates to a method of aligning and laminating for panels.

### Description of Related Art

The color cholesterol liquid crystal display (ChLCD) is formed by stacking a plurality of single color cholesterol liquid panels, and the issue that the single color cholesterol liquid panels accurately aligned and laminated to form the ChLCD becomes important, such as the disclosure in Publication Number US 2010/002183 A1.

In particular, the clear image of the alignment marks of each of the small-sized panels can be captured via the laminating equipment by disposing the thin glass substrate. However, the thin glass substrate is not suitable for the medium-sized panels and the large-sized panels owing to the low strength thereof so as to easily cause the damage during the placement or the touch.

Furthermore, under the condition of aligning and laminating the medium-sized panels and the large-sized panels, which are not thin, the clarity of the image, which is captured via the cameras of the laminating equipment, of each of the alignment marks of the panel disposed on bottom or top is easily interfered by each of the alignment marks of the panel disposed on the middle position. Hence, the aforementioned problem is attempted to solve by the following solutions of the prior art, such as eliminating the alignment marks of the panel disposed on the middle position via the laser or the chemical agents before the laminating process, but the panels are easily damaged or polluted via the aforementioned solution; or canceling the alignment marks of the panel disposed on the middle position by modifying the photomask of the panel disposed on the middle position, but the additional investment of the expensive photomask is required via the aforementioned solution.

Therefore, a method of aligning and laminating for panels and an alignment mark, which the additional processing is not required and the pollution and the damage are avoided, needs to be developed.

### SUMMARY

According to the present invention, the scope of protection of which is defined in the appended claims, a method of aligning and laminating for panels includes forming four alignment marks on each of a plurality of the panels via a photomask, aligning and laminating the first panel and the second panel to form a double layer panel and aligning and laminating the double layer panel and the third panel to form a triple layer panel. The panels include a first panel, a second panel and a third panel, the alignment marks are located on four corners of each of the panels, respectively, the alignment marks are a first corner mark, a second corner mark, a third corner mark and a shifting mark, the first corner mark and the second corner mark are symmetrical, the second corner mark and the third corner mark are symmetrical, and the shifting mark is asymmetric to all of the first corner mark, the second corner mark and the third corner mark. The second panel is rotated 180 degrees relatively to the first panel, the first corner mark of the first panel is aligned to the third corner mark of the second panel, the third corner mark of the first panel is aligned to the first corner mark of the second panel, and the double layer panel is formed after laminating. The second corner mark of the first panel is aligned to the second corner mark of the third panel, the shifting mark of the first panel is aligned to the shifting mark of the third panel, and the triple layer panel is formed after laminating.

According to the method of aligning and laminating for the panels of the foregoing aspect, the panels further include a fourth panel in forming the alignment marks on each of the panels via the photomask.

According to the method of aligning and laminating for the panels of the foregoing aspect, the method of aligning and laminating for the panels further include aligning and laminating the triple layer panel and the fourth panel to form a quadruple layer panel, wherein the fourth panel is rotated 180 degrees relatively to the first panel and the third panel, the shifting mark of the second panel is aligned to the shifting mark of the fourth panel, the second corner mark of the second panel is aligned to the second corner mark of the fourth panel, and the quadruple layer panel is formed after laminating.

According to the method of aligning and laminating for the panels of the foregoing aspect, at least two cameras are configured to capture in aligning and laminating the first panel and the second panel to form the double layer panel, aligning and laminating the double layer panel and the third panel to form the triple layer panel and aligning and laminating the triple layer panel and the fourth panel to form the quadruple layer panel, and the at least two cameras are simultaneously disposed above or below the double layer panel, the triple layer panel and the quadruple layer panel.

According to the method of aligning and laminating for the panels of the foregoing aspect, a number of the at least two cameras is four, two of the four cameras are disposed above the double layer panel, the triple layer panel and the quadruple layer panel, and the other two of the four cameras are disposed below the double layer panel, the triple layer panel and the quadruple layer panel.

According to the method of aligning and laminating for the panels of the foregoing aspect, each of the first panel, the second panel, the third panel and the fourth panel is a cholesterol liquid panel.

According to the method of aligning and laminating for the panels of the foregoing aspect, the first panel, the second panel, the third panel and the fourth panel are the panels of different colors.

According to the method of aligning and laminating for the panels of the foregoing aspect, each of the first panel, the second panel, the third panel and the fourth panel includes a display area, and each of the four alignment marks is located on an area outside of the display area.

### BRIEF DESCRIPTION OF THE DRAWINGS

Fig. 1 is a step flow chart of a method of aligning and laminating for panels according to the example of the present disclosure.
Fig. 2 is a schematic view of a photomask according to the example in Fig. 1.
Fig. 3 is a schematic view of a first panel according to the example in Fig. 1.
Fig. 4 is a schematic view of a second panel according to the example in Fig. 1.
Fig. 5 is a schematic view of a third panel according to the example in Fig. 1.
Fig. 6 is a schematic view of a fourth panel according to the example in Fig. 1.
Fig. 7 is a schematic view of aligning and laminating the first panel and the second panel according to the example in Fig. 1.
Fig. 8 is a schematic view of aligning and laminating the double layer panel and the third panel according to the example in Fig. 1.
Fig. 9 is a schematic view of aligning and laminating the triple layer panel and the fourth panel according to the example in Fig. 1.
Fig. 10 is a schematic view of an alignment mark according to the example in Fig. 1.

### DETAILED DESCRIPTION

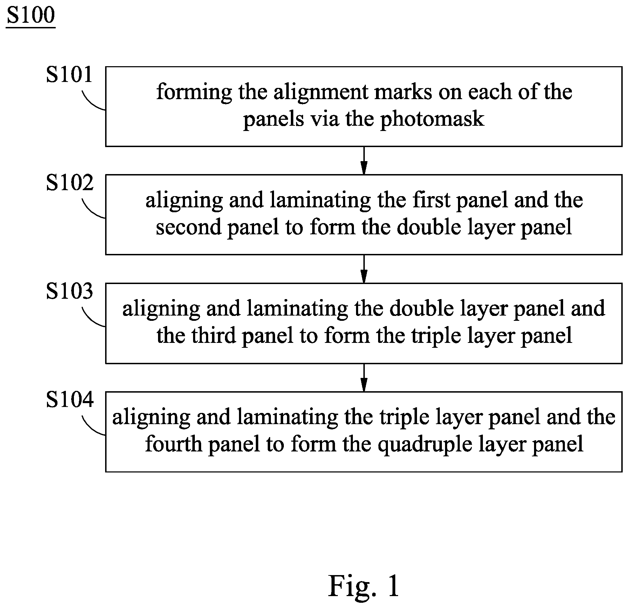

Fig. 1 is a step flow chart of a method of aligning and laminating for panels according to the example of the present disclosure. In Fig. 1, the method S100 of aligning and laminating for the panels includes steps S101, S102, S103.

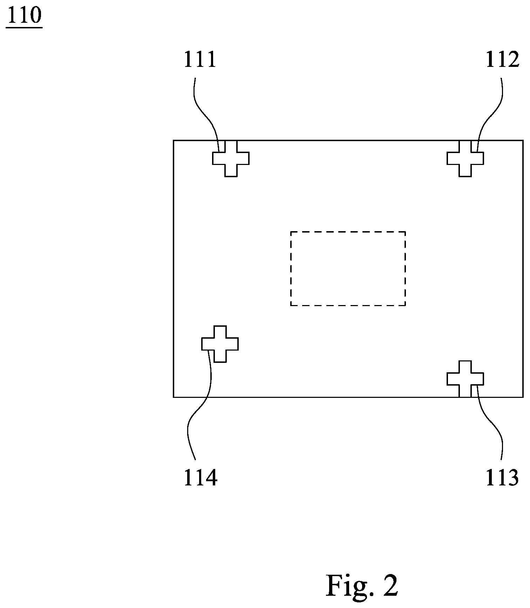

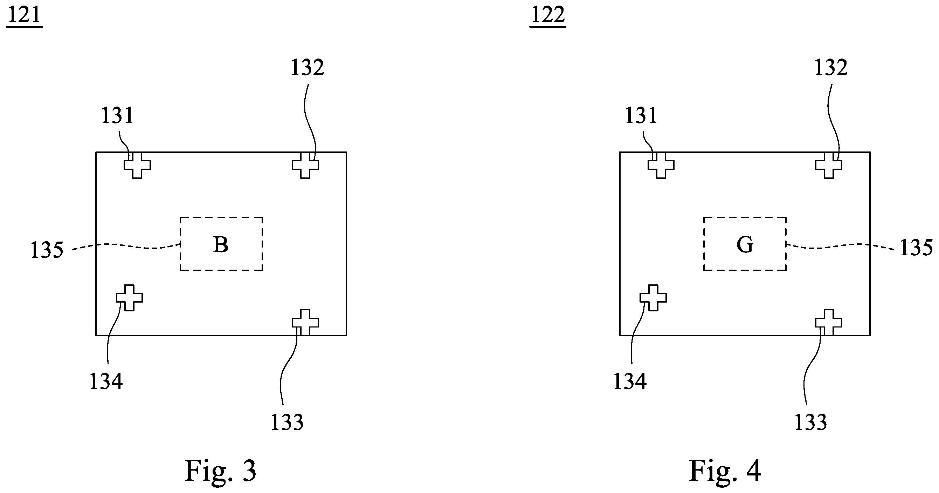

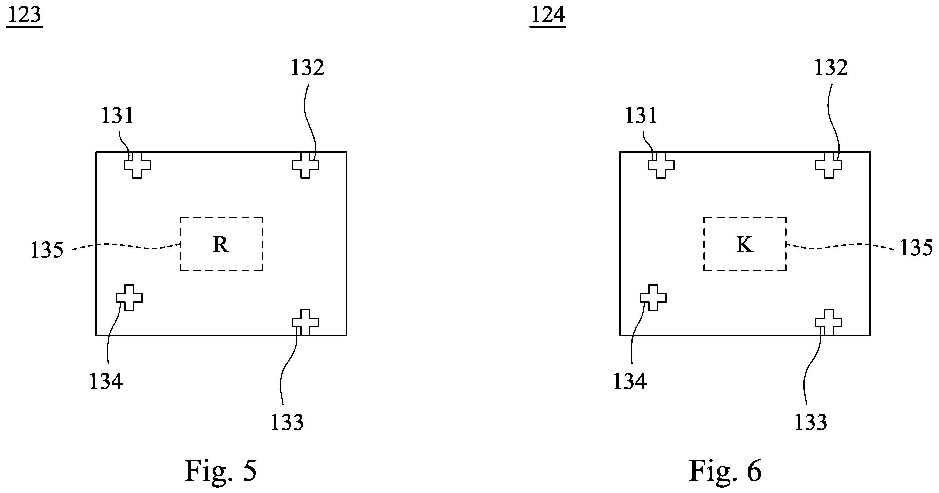

Fig. 2 is a schematic view of a photomask according to the example in Fig. 1. Fig. 3 is a schematic view of a first panel according to the example in Fig. 1. Fig. 4 is a schematic view of a second panel according to the example in Fig. 1. Fig. 5 is a schematic view of a third panel according to the example in Fig. 1. In Figs. 1 to 5, the step S101 includes forming four alignment marks on each of a plurality of the panels via the photomask 110, wherein the panels include the first panel 121, the second panel 122 and the third panel 123, the alignment marks are located on four corners of each of the panels (that is, the first panel 121, the second panel 122 and the third panel 123), respectively, and the alignment marks are a first corner mark 131, a second corner mark 132, a third corner mark 133 and a shifting mark 134.

Furthermore, the first corner mark 131 and the second corner mark 132 are symmetrical, and the second corner mark 132 and the third corner mark 133 are symmetrical, wherein the shifting mark 134 is asymmetric to all of the first corner mark 131, the second corner mark 132 and the third corner mark 133. In other words, the shifting mark 134 is shifted from the original position, which is symmetrical to the first corner mark 131 and the third corner mark 133.

Fig. 6 is a schematic view of a fourth panel according to the example in Fig. 1. In Fig. 6, the panels can further include the fourth panel 124, and the first corner mark 131, the second corner mark 132, the third corner mark 133 and the shifting mark 134 are located on four corners of the fourth panel 124. Moreover, each of the first panel 121, the second panel 122, the third panel 123 and the fourth panel 124 can be a cholesterol liquid panel, and the first panel 121, the second panel 122, the third panel 123 and the fourth panel 124 can be the panels of different colors, wherein the first panel 121 can be a blue cholesterol liquid panel, the second panel 122 can be a green cholesterol liquid panel, the third panel 123 can be a red cholesterol liquid panel, the fourth panel 124 can be a black cholesterol liquid panel, and B, G, R, K in Figs. 3-6 are configured to indicate blue, green, red and black, respectively, but the present disclosure is not limited thereto. Further, each of the first panel 121, the second panel 122, the third panel 123 and the fourth panel 124 can be formed via a photolithography process.

**In** Fig. 2, a plurality of marks 111, 112, 113, 114 are disposed on the photomask 110, and the mark 114 is asymmetric to all of the marks 111, 112, 113, wherein the position of each of the marks 111, 112, 113, 114 is corresponding to the position of each of the first corner mark 131, the second corner mark 132, the third corner mark 133 and the shifting mark 134 of each of the first panel 121, the second panel 122, the third panel 123 and the fourth panel 124.

**In** Figs. 3 to 6, each of the first panel 121, the second panel 122, the third panel 123 and the fourth panel 124 can include a display area 135, and each of the alignment marks (that is, the first corner mark 131, the second corner mark 132, the third corner mark 133 and the shifting mark 134) is located on an area outside of the display area 135.

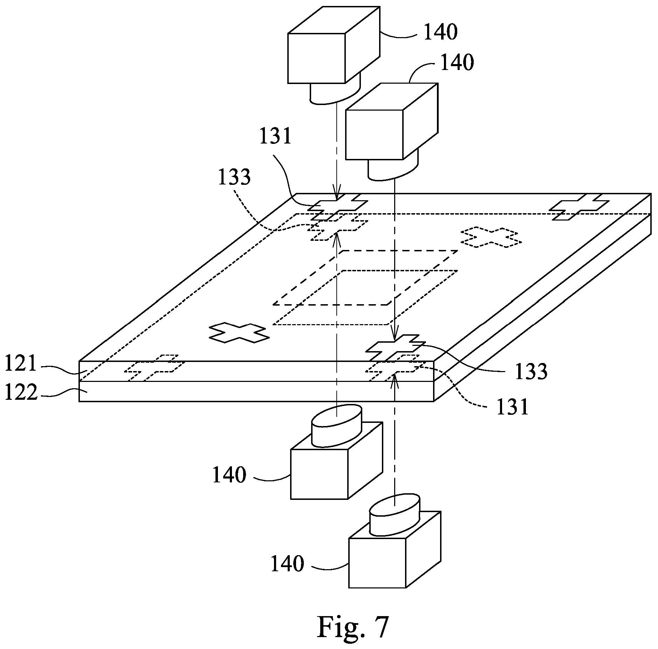

Fig. 7 is a schematic view of aligning and laminating the first panel and the second panel according to the example in Fig. 1. **In** Figs. 1 and 7, the step S102 includes aligning and laminating the first panel 121 and the second panel 122 to form a double layer panel, wherein the second panel 122 is rotated 180 degrees relatively to the first panel 121, the first corner mark 131 of the first panel 121 is aligned to the third corner mark 133 of the second panel 122, the third corner mark 133 of the first panel 121 is aligned to the first corner mark 131 of the second panel 122, and the double layer panel is formed after laminating.

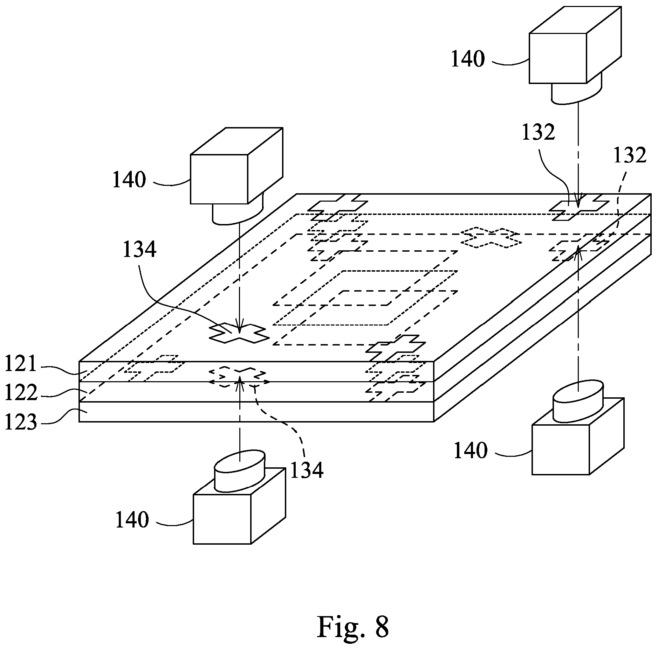

Fig. 8 is a schematic view of aligning and laminating the double layer panel and the third panel according to the example in Fig. 1. **In** Figs. 1 and 8, the step S103 includes aligning and laminating the double layer panel and the third panel 123 to form a triple layer panel, wherein the second corner mark 132 of the first panel 121 is aligned to the second corner mark 132 of the third panel 123, the shifting mark 134 of the first panel 121 is aligned to the shifting mark 134 of the third panel 123, and the triple layer panel is formed after laminating. It should be mentioned that the alignment of the second corner mark 132 of the first panel 121 and the second corner mark 132 of the third panel 123 is not influenced and interfered by the shifting mark 134 of the second panel 122, and the alignment of the shifting mark 134 of the first panel 121 and the shifting mark 134 of the third panel 123 is not influenced and interfered by the second corner mark 132 of the second panel 122.

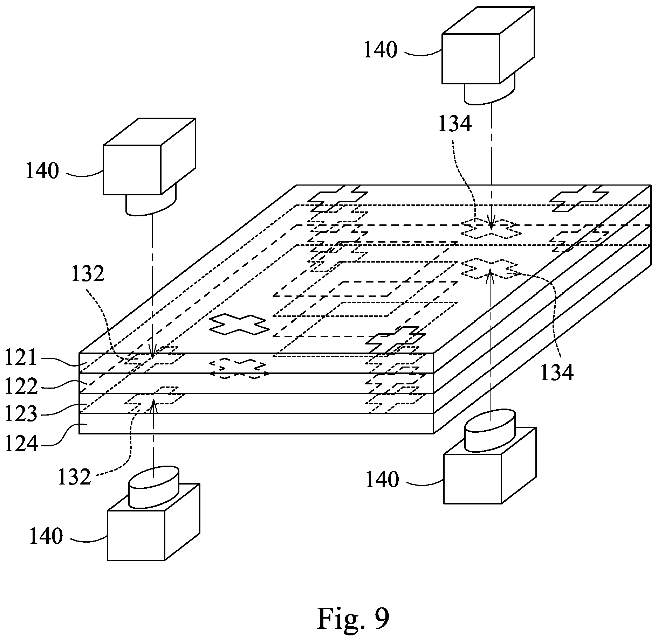

Fig. 9 is a schematic view of aligning and laminating the triple layer panel and the fourth panel according to the example in Fig. 1. In Figs. 1 and 9, the method S100 of aligning and laminating for the panels can further include a step S104, and the step S104 includes aligning and laminating the triple layer panel and the fourth panel 124 to form a quadruple layer panel, wherein the fourth panel 124 is rotated 180 degrees relatively to the first panel 121 and the third panel 123, the shifting mark 134 of the second panel 122 is aligned to the shifting mark 134 of the fourth panel 124, the second corner mark 132 of the second panel 122 is aligned to the second corner mark 132 of the fourth panel 124, and the quadruple layer panel is formed after laminating. It should be mentioned that the alignment of the shifting mark 134 of the second panel 122 and the shifting mark 134 of the fourth panel 124 is not influenced and interfered by the second corner mark 132 of the first panel 121 and the second corner mark 132 of the third panel 123, and the alignment of the second corner mark 132 of the second panel 122 and the second corner mark 132 of the fourth panel 124 is not influenced and interfered by the shifting mark 134 of the first panel 121 and the shifting mark 134 of the third panel 123.

In Figs. 7 to 9, at least two cameras 140 can be configured to capture in aligning and laminating the first panel 121 and the second panel 122 to form the double layer panel, aligning and laminating the double layer panel and the third panel 123 to form the triple layer panel and aligning and laminating the triple layer panel and the fourth panel 124 to form the quadruple layer panel, and the cameras 140 are simultaneously disposed above or below the double layer panel, the triple layer panel and the quadruple layer panel. Furthermore, a number of the cameras 140 can be four, two of the cameras 140 are disposed above the double layer panel, the triple layer panel and the quadruple layer panel, and the other two of the cameras 140 are disposed below the double layer panel, the triple layer panel and the quadruple layer panel. It should be mentioned that the number of the cameras 140 can be corresponding to the manufacturing requirement, and the present disclosure is not limited thereto.

Furthermore, a laminating sequence of the first panel 121, the second panel 122, the third panel 123 and the fourth panel 124 can be from top to bottom or from bottom to top, and a thickness of each of the first panel 121, the second panel 122, the third panel 123 and the fourth panel 124 can be between 0.2 mm and 0.5 mm, and an area of each of the first panel 121, the second panel 122, the third panel 123 and the fourth panel 124 can be between 13.3 inch and 27.6 inch, but the present disclosure is not limited thereto.

It should be mentioned that the shifting marks 134 in Figs. 7 to 9 are presented in X-shaped and highlighted the shifting positions thereof for emphasizing the other marks (that is, the first corner marks 131, the second corner marks 132 and the third corner marks 133) are not influenced via the shifting marks 134 or do not influence the shifting marks 134 during aligning and laminating. In actual, the shifting marks 134 are the same as the first corner marks 131, the second corner marks 132 and the third corner marks 133 as cross-shaped on the panels, as shown in the schematic views of Figs. 3 to 6. Further, the shifting marks 134 can be X-shaped shown as Figs. 7 to 9 or the shape different from the shape of each of the first corner marks 131, the second corner marks 132 and the third corner marks 133. That is, a shape of the shifting mark 134 of each of the panels can be different from a shape of each of the first corner mark 131, the second corner mark 132 and the third corner mark 133 of each of the panels, so that the effect of avoiding the shifting marks 134 influenced via the other marks or influencing the other marks during aligning and laminating can be achieved.

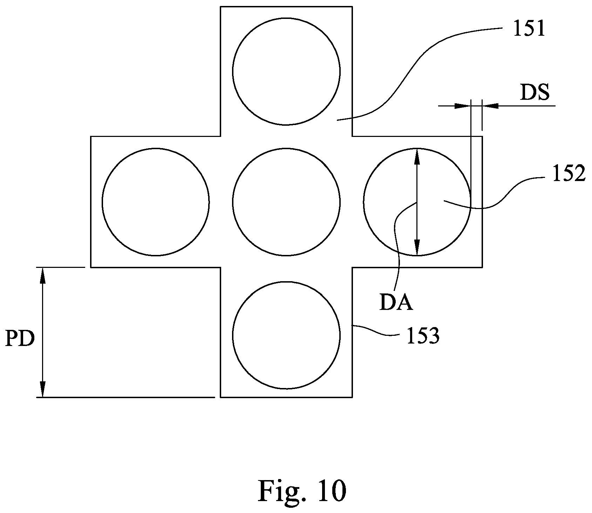

Fig. 10 is a schematic view of an alignment mark according to the example in Fig. 1. In Fig. 10, the alignment mark (its reference numeral is omitted) includes a first area 151 and a plurality of second areas 152, the first area 151 is formed by surrounding via a plurality of boundaries 153, and the second areas 152 are located in the first area 151, wherein the second areas 152 let a light pass through, and the other area of the first area 151 excepting from the second areas 152 prohibit the light from passing through. Moreover, a distance DS between one of the boundaries 153 of the first area 151 and one of the second areas 152 is less than or equal to 0.02 mm, wherein the distance DS between one of the boundaries 153 of the first area 151 and one of the second areas 152 can be between 0.01 mm and 0.02 mm. Further, the alignment mark is disposed on a panel. In particular, the coaxial light source can be avoided being entirely blocked to pass through from the alignment mark.

In detail, the alignment mark in Fig. 10 can be each of the first corner mark 131, the second corner mark 132, the third corner mark 133 and the shifting mark 134 of each of the first panel 121, the second panel 122, the third panel 123 and the fourth panel 124 and each of the marks 111, 112, 113, 114 of the photomask 110.

The first area 151 can be made of metal, and a length PD of each of the boundaries 153 can be less than or equal to 0.18 mm, wherein a number of the boundaries 153 of the first area 151 can be plurality, and the length PD of each of the boundaries 153 can be the same. In particular, the aforementioned values are based on the capabilities of the exposure process, the development process and the etching process of the lithography process, and the aforementioned values are also related to the lens magnification and the field of view, which can be provided, of each of the cameras 140.

A number of the second areas 152 can be five, wherein the second areas 152 are located on four corners and a center position of the alignment mark, respectively. Further, the first area 151 can be cross-shaped, each of the second areas 152 can be circle, and a diameter DA of each of the second areas 152 can be less than 0.18 mm, but the present disclosure is not limited to the aforementioned number and shape.

In Fig. 10, the distance DS between one of the boundaries 153 of the first area 151 and one of the second areas 152 is 0.015 mm, the diameter DA of each of the second areas 152 is 0.15 mm, and the length PD of each of the boundaries 153 is 0.18 mm.

In summary, the method of aligning and laminating for the panels of the present disclosure is favorable for achieving the effect of forming four panels via the same photomask and accurately laminating and aligning the panels, wherein the alignment marks at the diagonal of each panel do not interfere with the alignment during aligning and laminating, and the method of aligning and laminating for the panels can be applied to different panel sizes of the panels. Therefore, the processes and the manufacturing cost can be reduced, and the problems of damaging or polluting the panels via the photomask can be solved. Further, the effect of the alignment can be further enhanced via the alignment mark of the present disclosure, and the clear image of the alignment marks can be captured via the cameras for obtaining the accurate alignment to process the aligning process and the laminating process.

## Claims

1. A method of aligning and laminating for panels (S100), **characterized in** comprising:
forming four alignment marks on each of a plurality of the panels via a photomask (110), wherein the panels comprise a first panel (121), a second panel (122) and a third panel (123), the four alignment marks are located on four corners of each of the panels, respectively, the four alignment marks are a first corner mark (131), a second corner mark (132), a third corner mark (133) and a shifting mark (134), the first corner mark (131) and the second corner mark (132) are symmetrical, the second corner mark (132) and the third corner mark (133) are symmetrical, and the shifting mark (134) is asymmetric to all of the first corner mark (131), the second corner mark (132) and the third corner mark (133);
aligning and laminating the first panel (121) and the second panel (122) to form a double layer panel, wherein the second panel (122) is rotated 180 degrees relatively to the first panel (121), the first corner mark (131) of the first panel (121) is aligned to the third corner mark (133) of the second panel (122), the third corner mark (133) of the first panel (121) is aligned to the first corner mark (131) of the second panel (122), and the double layer panel is formed after laminating; and
aligning and laminating the double layer panel and the third panel (123) to form a triple layer panel, wherein the second corner mark (132) of the first panel (121) is aligned to the second corner mark (132) of the third panel (123), the shifting mark (134) of the first panel (121) is aligned to the shifting mark (134) of the third panel (123), and the triple layer panel is formed after laminating.

2. The method of aligning and laminating for the panels (S100) of claim 1, wherein the panels further comprise a fourth panel (124) in forming the four alignment marks on each of the panels via the photomask (110).

3. The method of aligning and laminating for the panels (S100) of any of claims 1-2, further comprising:
aligning and laminating the triple layer panel and the fourth panel (124) to form a quadruple layer panel, wherein the fourth panel (124) is rotated 180 degrees relatively to the first panel (121) and the third panel (123), the shifting mark (134) of the second panel (122) is aligned to the shifting mark (134) of the fourth panel (124), the second corner mark (132) of the second panel (122) is aligned to the second corner mark (132) of the fourth panel (124), and the quadruple layer panel is formed after laminating.

4. The method of aligning and laminating for the panels (S100) of any of claims 1-3, wherein at least two cameras (140) are configured to capture in aligning and laminating the first panel (121) and the second panel (122) to form the double layer panel, aligning and laminating the double layer panel and the third panel (123) to form the triple layer panel and aligning and laminating the triple layer panel and the fourth panel (124) to form the quadruple layer panel, and the at least two cameras (140) are simultaneously disposed above or below the double layer panel, the triple layer panel and the quadruple layer panel.

5. The method of aligning and laminating for the panels (S100) of any of claims 1-4, wherein a number of the at least two cameras (140) is four, two of the four cameras (140) are disposed above the double layer panel, the triple layer panel and the quadruple layer panel, and the other two of the four cameras (140) are disposed below the double layer panel, the triple layer panel and the quadruple layer panel.

6. The method of aligning and laminating for the panels (S100) of any of claims 1-5, wherein each of the first panel (121), the second panel (122), the third panel (123) and the fourth panel (124) is a cholesterol liquid panel.

7. The method of aligning and laminating for the panels (S100) of any of claims 1-6, wherein the first panel (121), the second panel (122), the third panel (123) and the fourth panel (124) are the panels of different colors.

8. The method of aligning and laminating for the panels (S100) of any of claims 1-7, wherein each of the first panel (121), the second panel (122), the third panel (123) and the fourth panel (124) comprises a display area (135), and each of the four alignment marks is located on an area outside of the display area (135).

## Patentansprüche

1. Verfahren zum Ausrichten und Laminieren von Platten (S100), **dadurch gekennzeichnet, dass** es Folgendes umfasst:
Bilden von vier Ausrichtungsmarken an jeder einer Vielzahl der Platten über eine Fotomaske (110), wobei die Platten eine erste Platte (121), eine zweite Platte (122) und eine dritte Platte (123) umfassen, sich die vier Ausrichtungsmarken jeweils an vier Ecken jeder der Platten befinden, die vier Ausrichtungsmarken eine erste Eckmarke (131), eine zweite Eckmarke (132), eine dritte Eckmarke (133) und eine Verschiebungsmarke (134) sind, die erste Eckmarke (131) und die zweite Eckmarke (132) symmetrisch sind, die zweite Eckmarke (132) und die dritte Eckmarke (133) symmetrisch sind und die Verschiebungsmarke (134) sowohl gegenüber der ersten Eckmarke (131) als auch der zweiten Eckmarke (132) und der dritten Eckmarke (133) asymmetrisch ist;
Ausrichten und Laminieren der ersten Platte (121) und der zweiten Platte (122) zur Bildung einer doppelschichtigen Platte, wobei die zweite Platte (122) relativ zu der ersten Platte (121) um 180 Grad gedreht wird, die erste Eckmarke (131) der ersten Platte (121) mit der dritten Eckmarke (133) der zweiten Platte (122) ausgerichtet wird, die dritte Eckmarke (133) der ersten Platte (121) mit der ersten Eckmarke (131) der zweiten Platte (122) ausgerichtet wird und die doppelschichtige Platte nach dem Laminieren gebildet wird, und
Ausrichten und Laminieren der doppelschichtigen Platte und der dritten Platte (123) zur Bildung einer dreischichtigen Platte, wobei die zweite Eckmarke (132) der ersten Platte (121) mit der zweiten Eckmarke (132) der dritten Platte (123) ausgerichtet wird, die Verschiebungsmarke (134) der ersten Platte (121) mit der Verschiebungsmarke (134) der dritten Platte (123) ausgerichtet wird und die dreischichtige Platte nach dem Laminieren gebildet wird.

2. Verfahren zum Ausrichten und Laminieren der Platten (S100) nach Anspruch 1, wobei die Platten beim Bilden der vier Ausrichtungsmarken auf jeder der Platten über die Fotomaske (110) ferner eine vierte Platte (124) umfassen.

3. Verfahren zum Ausrichten und Laminieren der Platten (S100) nach einem der Ansprüche 1-2, das ferner Folgendes umfasst:
Ausrichten und Laminieren der dreischichtigen Platte und der vierten Platte (124) zur Bildung einer vierschichtigen Platte, wobei die vierte Platte (124) relativ zu der ersten Platte (121) und der dritten Platte (123) um 180 Grad gedreht wird, die Verschiebungsmarke (134) der zweiten Platte (122) mit der Verschiebungsmarke (134) der vierten Platte (124) ausgerichtet wird, die zweite Eckmarke (132) der zweiten Platte (122) mit der zweiten Eckmarke (132) der vierten Platte (124) ausgerichtet wird und die vierschichtige Platte nach dem Laminieren gebildet wird.

4. Verfahren zum Ausrichten und Laminieren der Platten (S100) nach einem der Ansprüche 1-3, wobei mindestens zwei Kameras (140) zum Erfassen beim Ausrichten und Laminieren der ersten Platte (121) und der zweiten Platte (122) zur Bildung der doppelschichtigen Platte, beim Ausrichten und Laminieren der doppelschichtigen Platte und der dritten Platte (123) zur Bildung der dreischichtigen Platte sowie beim Ausrichten und Laminieren der dreischichtigen Platte und der vierten Platte (124) zur Bildung der vierschichtigen Platte ausgelegt sind, und wobei die mindestens zwei Kameras (140) gleichzeitig oberhalb oder unterhalb der doppelschichtigen Platte, der dreischichtigen Platte und der vierschichtigen Platte angeordnet sind.

5. Verfahren zum Ausrichten und Laminieren der Platten (S100) nach einem der Ansprüche 1-4, wobei eine Anzahl der mindestens zwei Kameras (140) vier beträgt, zwei der vier Kameras (140) oberhalb der doppelschichtigen Platte, der dreischichtigen Platte und der vierschichtigen Platte angeordnet sind und die anderen beiden der vier Kameras (140) unterhalb der doppelschichtigen Platte, der dreischichtigen Platte und der vierschichtigen Platte angeordnet sind.

6. Verfahren zum Ausrichten und Laminieren der Platten (S100) nach einem der Ansprüche 1-5, wobei die erste Platte (121), die zweite Platte (122), die dritte Platte (123) und die vierte Platte (124) jeweils eine Cholesterin-Flüssigkeitsplatte ist.

7. Verfahren zum Ausrichten und Laminieren der Platten (S100) nach einem der Ansprüche 1-6, wobei die erste Platte (121), die zweite Platte (122), die dritte Platte (123) und die vierte Platte (124) Platten unterschiedlicher Farben sind.

8. Verfahren zum Ausrichten und Laminieren der Platten (S100) nach einem der Ansprüche 1-7, wobei die erste Platte (121), die zweite Platte (122), die dritte Platte (123) und die vierte Platte (124) jeweils einen Anzeigebereich (135) aufweisen und sich jede der vier Ausrichtungsmarken in einem Bereich außerhalb des Anzeigebereichs (135) befindet.

## Revendications

1. Procédé d'alignement et de stratification pour panneaux (S100), **caractérisé en ce qu'**il comprend :
la formation de quatre repères d'alignement sur chacun d'une pluralité de panneaux à l'aide d'un photomasque (110), les panneaux comprenant un premier panneau (121), un deuxième panneau (122) et un troisième panneau (123), les quatre repères d'alignement sont situés respectivement aux quatre coins de chacun des panneaux, les quatre repères d'alignement sont un premier repère de coin (131), un deuxième repère de coin (132), un troisième repère de coin (133) et un repère de décalage (134), le premier repère de coin (131) et le deuxième repère de coin (132) sont symétriques, le deuxième repère de coin (132) et le troisième repère de coin (133) sont symétriques, et le repère de décalage (134) est asymétrique par rapport au premier repère de coin (131), au deuxième repère de coin (132) et au troisième repère de coin (133) ;
l'alignement et la stratification du premier panneau (121) et du deuxième panneau (122) pour former un panneau à double couche, dans lequel le deuxième panneau (122) est tourné de 180 degrés par rapport au premier panneau (121), le premier repère de coin (131) du premier panneau (121) est aligné avec le troisième repère de coin (133) du deuxième panneau (122), le troisième repère de coin (133) du premier panneau (121) est aligné avec le premier repère de coin (131) du deuxième panneau (122), et le panneau à double couche est formé après stratification ; et
l'alignement et la stratification du panneau à double couche et du troisième panneau (123) pour former un panneau à triple couche, le deuxième repère de coin (132) du premier panneau (121) étant aligné avec le deuxième repère de coin (132) du troisième panneau (123), le repère de décalage (134) du premier panneau (121) étant aligné avec le repère de décalage (134) du troisième panneau (123), et le panneau à triple couche est formé après stratification.

2. Procédé d'alignement et de stratification pour les panneaux (S100) selon la revendication 1, dans lequel les panneaux comprennent en outre un quatrième panneau (124) lors de la formation des quatre repères d'alignement sur chacun des panneaux à l'aide du photomasque (110).

3. Procédé d'alignement et de stratification pour les panneaux (S100) selon l'une quelconque des revendications 1 à 2, comprenant en outre :
l'alignement et la stratification du panneau à triple couche et du quatrième panneau (124) pour former un panneau à quadruple couche, dans lequel le quatrième panneau (124) est tourné de 180 degrés par rapport au premier panneau (121) et au troisième panneau (123), le repère de décalage (134) du deuxième panneau (122) est aligné avec le repère de décalage (134) du quatrième panneau (124), le deuxième repère de coin (132) du deuxième panneau (122) est aligné avec le deuxième repère de coin (132) du quatrième panneau (124), et le panneau à quadruple couche est formé après stratification.

4. Procédé d'alignement et de stratification pour les panneaux (S100) selon l'une quelconque des revendications 1 à 3, dans lequel au moins deux caméras (140) sont configurées pour capturer, lors de l'alignement et de la stratification du premier panneau (121) et du deuxième panneau (122) afin de former le panneau à double couche, l'alignement et la stratification du panneau à double couche et du troisième panneau (123) pour former le panneau à triple couche, ainsi que l'alignement et la stratification du panneau à triple couche et du quatrième panneau (124) pour former le panneau à quadruple couche, et les au moins deux caméras (140) sont disposées simultanément au-dessus ou au-dessous du panneau à double couche, du panneau à triple couche et du panneau à quadruple couche.

5. Procédé d'alignement et de stratification pour les panneaux (S100) selon l'une quelconque des revendications 1 à 4, dans lequel le nombre des au moins deux caméras (140) est égal à quatre, deux des quatre caméras (140) sont disposées au-dessus du panneau à double couche, du panneau à triple couche et du panneau à quadruple couche, et les deux autres des quatre caméras (140) sont disposées au-dessous du panneau à double couche, du panneau à triple couche et du panneau à quadruple couche.

6. Procédé d'alignement et de stratification pour les panneaux (S100) selon l'une quelconque des revendications 1 à 5, dans lequel chacun des premier panneau (121), deuxième panneau (122), troisième panneau (123) et quatrième panneau (124) est un panneau à liquide cholestérol.

7. Procédé d'alignement et de stratification pour les panneaux (S100) selon l'une quelconque des revendications 1 à 6, dans lequel le premier panneau (121), le deuxième panneau (122), le troisième panneau (123) et le quatrième panneau (124) sont des panneaux de couleurs différentes.

8. Procédé d'alignement et de stratification pour les panneaux (S100) selon l'une quelconque des revendications 1 à 7, dans lequel chacun des premier panneau (121), deuxième panneau (122), troisième panneau (123) et quatrième panneau (124) comporte une zone d'affichage (135), et chacun des quatre repères d'alignement est situé sur une zone située à l'extérieur de la zone d'affichage (135).
